# FASCICULE DE BREVET EUROPEEN

(11) **EP 1 283 990 B1**
(45) Date de publication et mention de la délivrance du brevet: **08.06.2011**
(21) Numéro de dépôt: 01921485.7
(22) Date de dépôt: 05.04.2001
(51) Int. Cl.: G01R 29/08

(54) **DISPOSITIF D'ESSAI EN COMPATIBILITE ELECTROMAGNETIQUE**
EINRICHTUNG ZUR ERMITTLUNG DER ELEKTROMAGNETISCHEN VERTRÄGLICHKEIT
ELECTROMAGNETIC COMPATIBILITY TESTING DEVICE

(30) Priorité: 16.05.2000 FR 0006193
(43) Date de publication de la demande: 19.02.2003
(73) Titulaire: Institit Français des Sciences et Technologies des Transports, de l' Aménagement et des réseaux, 69675 Bron CEDEX (FR)
(72) Inventeur: KLINGLER, Marco, 59000 Lille (FR); RIOULT, Jean, F-59000 Lille (FR); GHYS, Jean-Pierre, F-59310 Sameon (FR)
(74) Mandataire: Brema-Loyer
(86) Numéro de dépôt international: PCT/FR2001/001025
(87) Numéro de publication internationale: WO 2001/088554

(56) Documents cités:
- WO-A-97/34158
- CAI X.-D., COSTACHE GEORGE I.: "Finite-Element Analysis of a Triple-TEM Cell" IEEE TRANSACTIONS ON ELECTROMAGNETIC COMPATIBILITY, vol. 36, no. 4, 1 novembre 1994 (1994-11-01), pages 398-404, XP000619373

## Description

Objet de l'invention est un dispositif d'essai permettant de mesurer le L'objet de l'invention est un dispositif d'essai permettant de mesurer le rayonnement, l'immunité et les caractéristiques électromagnétiques d'un objet à tester, comportant une structure conductrice enveloppant un volume d'essai dans lequel on peut placer ledit objet, ladite structure étant munie d'une ouverture obturable, ledit dispositif d'essai comportant également un ensemble de conducteurs internes appelés septa, en nombre au moins égal à deux, chaque septum étant composé d'au moins un conducteur, élémentaire, chaque septum étant relié à au moins un et au plus deux connecteurs traversant la structure, chaque connecteur étant relié à au moins un septum, chaque septum définissant dans ledit volume d'essai, par sa disposition dans la structure, un couplage électromagnétique avec ledit objet, ledit couplage électromagnétique étant précisé par un vecteur de couplage électrique et un vecteur de couplage magnétique définissant un plan de couplage électromagnétique.

On connaît et on utilise actuellement de tels dispositifs d'essai appelés cellules transverses électromagnétiques (cellules TEM) qui se distinguent principalement par la géométrie de leur structure métallique, par le nombre, la forme et la réalisation des septa, par la disposition desdits septa dans la structure, ainsi que par le nombre de connecteurs.

La publication IEEE Transactions on Electromagnetic Compatibility, Vol. 16, N°4, de novembre 1974 : « Génération of Standard EM Fields using TEM Transmission Cells » (M. Crawford) décrit la cellule TEM conventionnelle et son utilisation pour la création de champs électromagnétiques dans le but de mesurer l'immunité électromagnétique d'objets à tester. De forme polyédrique, la structure métallique de cette cellule comprend une section centrale de forme parallélépipédique entre deux sections pyramidales de transition. A chaque extrémité des sections de transition est placé un connecteur reliant les deux extrémités d'un septum de forme hexagonale situé à mi-hauteur à l'intérieur de la structure. Cette cellule n'est limitée qu'en hautes fréquences par l'apparition de modes de résonance en fonction des dimensions de la cavité formée par la structure métallique, fréquences à partir desquelles le mode de couplage transverse électromagnétique n'est plus vérifié.

Le rapport du National Bureau of Standards NBS N° TN-1059 (PB83-165274) d'octobre 1982 : « A Method to Quantify the Radiation Characteristics of an Unknown Interference Source » (M.T. Ma et G.H. Koepke) décrit un procédé de mesure de rayonnement électromagnétique exploitant une cellule TEM traditionnelle à un septum et deux connecteurs dans laquelle l'objet sous test est placé successivement selon plusieurs positions.

Le brevet US 4,837,581 décrit une cellule TEM de forme pyramidale dont le septum de forme triangulaire est relié, d'une part à un connecteur placé à l'extrémité de la structure formée par le sommet de la forme pyramidale, et d'autre part à un réseau de charges connecté à l'autre extrémité de la structure formée par la base de la forme pyramidale. Appelée cellule GTEM, cette cellule a la singularité de posséder également un ensemble d'éléments absorbant les ondes électromagnétiques sur la paroi intérieure connectée au réseau de charges permettant de l'utiliser à des fréquences bien supérieures à celles de la cellule TEM conventionnelle.

Les brevets US 5,754,054 ; US 5,404,098; US 5,825,331 et US 5,430,456 décrivent des procédés de mesure de rayonnement électromagnétique qui se distinguent du procédé de mesure décrit dans rapport NBS N° TN-1059 par le nombre de positions et les orientations de l'objet à tester ainsi que par l'utilisation d'une cellule GTEM.

Le brevet US 5,589,773 décrit un procédé de mesure de rayonnement et un système de positionnement adapté à une cellule GTEM, ledit système de positionnement permettant de faciliter et d'automatiser les changements d'orientation de l'équipement sous test.

Le brevet JP 05312866A décrit une cellule TEM traditionnelle comprenant un système d'insertion de l'objet à tester tandis que le brevet JP 05005763A décrit une cellule TEM traditionnelle comprenant dans le volume intérieur de la structure des éléments destinés au brassage du rayonnement électromagnétique.

Les brevets US 5,585,808 ; DE 39 25 247 A1 ; JP 02203281A ; JP 04353774A ; JP 05264620A et JP 06242161A décrivent des cellules TEM à un septum qui se distinguent par la forme géométrique de leur structure ainsi que par la forme géométrique et la disposition du septum à l'intérieur de la structure. Le brevet JP 10267975A décrit une cellule TEM qui se distingue de la cellule décrite dans le brevet JP 06242161A en ce que les parois internes de la structure sont recouvertes d'un matériau absorbant l'énergie électromagnétique.

Le brevet US 5,910,729 décrit une cellule TEM comportant deux septa, chacun d'eux étant relié à ses deux extrémités à un connecteur. La disposition symétrique des deux septa est conçue pour améliorer les performances de couplage électromagnétique. Le brevet US 5,942,903 décrit une cellule TEM qui se distingue essentiellement de la cellule décrite par le brevet US 5,910,729 par la forme de la structure, par la réalisation particulière des septa et par leur connexion à une extrémité à un réseau de charges. Le brevet US 5,861,753 décrit une cellule TEM qui se distingue de la cellule décrite par le brevet US 5,942,903 par la forme de la structure, et en ce qu'elle comporte trois septa et deux connecteurs, deux des trois septa étant disposés de manière symétrique dans la structure et connectés à un seul des connecteurs par un coupleur.

Le brevet US 5,793,215 décrit une cellule TEM qui se distingue de la cellule TEM décrite par le brevet US 5,910,729 en ce qu'elle comporte trois septa de forme cylindrique reliés aux deux extrémités de la structure par six connecteurs de traversée. Le brevet JP 11174102A décrit une cellule TEM qui se distingue essentiellement de la cellule TEM décrite par le brevet US 5,793,215 en ce que les trois septa sont de forme plane.

Le brevet JP 10185981A décrit une cellule TEM de forme principalement cylindrique comprenant un septum rotatif autour de l'axe longitudinal de la structure, ledit septum étant relié à un connecteur à chaque extrémité de la structure. En outre, la cellule TEM comprend un support rotatif permettant de tourner l'objet sous test autour de l'axe vertical. Le brevet DE 196 01 348 C1 décrit une cellule TEM à un seul septum rotatif à deux positionnements.

Les brevets US 5,327,091 et US 5,530,412 décrivent deux procédés de brassage des modes d'une cavité résonnante formée par une structure métallique fermée dépourvue de septum appelée chambre réverbérante à brassage de modes, à l'intérieur de laquelle sont notamment disposés l'objet sous test et une antenne émettant une énergie électromagnétique.

Dans les brevets US 5,910,729 ; US 5,942,903 ; US 5,861,753 ; US 5,793,215 et KR 97-64814 cités ci-dessus comprenant au moins deux septa, les plans de couplage électromagnétique desdits septa dans le volume d'essai sont confondus, c'est à dire que les vecteurs de couplage électrique et magnétique associés à chaque septum sont orientés dans un plan perpendiculaire à l'axe longitudinal des cellules TEM. Ceci est également le cas des cellules TEM ayant un septum rotatif et décrites dans les brevets KR 96-57363 et DE 196 01 348 C1, quelle que soit la disposition du septum dans la cellule. Dans tous les cas, la caractérisation électromagnétique des objets sous test s'effectue donc dans un repère bi-dimensionnel d'un même plan de couplage électromagnétique. Les cellules TEM décrites dans ces brevets ont été principalement développées pour mesurer les caractéristiques électromagnétiques d'objets selon plusieurs polarisations de couplage électromagnétique dans un même plan, notamment les polarisations verticale et horizontale, afin de reproduire les mesures effectuées en site ouvert ou en chambre anéchoïque où l'objet à tester est disposé à une certaine distance d'une antenne polarisée verticalement puis horizontalement. La caractérisation électromagnétique tridimensionnelle de l'objet sous test ne peut alors être obtenue que par des changements d'orientation de l'objet sous test dans le volume d'essai comme le précise le rapport NBS N° TN-1059 ainsi que les brevets US 5,754,054 ; US 5,404,098 ; US 5,825,331 ; US 5,430,456 et US 5,589,773.

Dans les chambres réverbérantes à brassage de modes décrites dans les brevets US 5,327,091 et US 5,530,412 cités ci-dessus, les plans de couplage électromagnétique dans le volume d'essai sont produites par une multitude d'ondes électromagnétiques issues de l'antenne d'émission et réfléchies par les parois conductrices de la structure métallique. Aux fréquences de résonance de la cavité de la structure, la superposition de l'ensemble de ces plans de couplage dans le volume d'essai confère à l'objet sous test un caractère statistiquement isotrope sur un cycle du brassage de modes, quelle que soit l'orientation dudit objet à tester. Ce dispositif d'essai et son fonctionnement sont néanmoins tributaires des dimensions géométriques de la structure qui définissent la première fréquence de résonance de la cavité ainsi que de la fréquence minimale pour laquelle le caractère isotrope de l'objet sous test est obtenu sur un cycle de brassage.

De même que les chambres réverbérantes à brassage de modes, et contrairement aux cellules TEM connues, le dispositif d'essai objet de l'invention permet d'éviter une manipulation de l'équipement sous test par la disposition particulière des septa dans la structure et permet de surcroît la simultanéité de mesures. Ceci constitue un avantage des dispositifs d'essai objet de l'invention. Cet objectif est atteint par un dispositif tel que défini dans la revendication 1.

Selon l'invention, le dispositif d'essai comporte trois septa disposés dans la structure de telle sorte que leurs plans de couplage électromagnétique soient deux à deux distincts et non parallèles. En outre, les plans de couplage électromagnétique peuvent être deux à deux orthogonaux.

Selon une variante de l'invention, le dispositif d'essai comporte deux groupes de trois septa, les septa de chaque groupe étant disposés dans la structure de telle sorte que leurs plans de couplage électromagnétique soient deux à deux distincts et non parallèles. En outre, les plans de couplage électromagnétique de chacun de ces groupes peuvent être deux à deux orthogonaux. Dans les dispositifs d'essai objet de l'invention, la structure peut être de forme polyédrique et plus particulièrement de forme parallélépipédique ou encore de forme cubique.

En général, les dimensions de la forme polyédrique du dispositif d'essai objet de l'invention peuvent être choisies d'une part pour fixer la première fréquence de résonance de la cavité de la structure et d'autre part pour augmenter le nombre de modes de résonance de la cavité en hautes fréquences. Ainsi le dispositif d'essai objet de l'invention pourra bénéficier des propriétés complémentaires des cellules TEM et des chambres réverbérantes à brassage de modes. En particulier, lorsque la structure est de forme parallélépipédique, les rapports des dimensions de cette forme, prises deux à deux, peuvent être des nombres irrationnels.

En outre, tout ou partie de la face intérieure de la structure d'un dispositif d'essai objet de l'invention peut être recouverte d'un matériau absorbant l'énergie électromagnétique et le volume intérieur de cette structure peut comporter des éléments destinés au brassage du rayonnement électromagnétique.
La figure 1 représente schématiquement et en perspective, avec vue partielle de l'intérieur, une cellule TEM traditionnelle à un septum et deux connecteurs, dont la partie centrale est de forme parallélépipédique.
La figure 2 représente schématiquement et en perspective, avec vue partielle de l'intérieur, une cellule GTEM de forme pyramidale à un septum et un connecteur, décrite dans le brevet US 4,837,581.
La figure 3 représente schématiquement et en perspective une cellule TEM à trois septa et six connecteurs, décrite dans le brevet US 5,793,215.
Les figures 4a et 4b représentent schématiquement deux coupes longitudinales d'une cellule TEM à trois septa et deux connecteurs, décrite dans le brevet US 5,861,753.
Les figures 5a à 5d montrent une réalisation générique d'un dispositif d'essai objet de l'invention qui se caractérise par la disposition de trois septa dont les plans de couplage électromagnétique sont deux à deux orthogonaux et dont la structure est de forme parallélépipédique. La figure 5a est une représentation en perspective, avec vue partielle de l'intérieur ; les figures 5b à 5d sont des coupes transversales selon trois plans orthogonaux passant par le centre de l'objet à tester.
Les figures 6a à 6d montrent une réalisation particulière d'un dispositif d'essai objet de l'invention dérivée du dispositif d'essai représenté aux figures 5a à 5d, dont la structure est de forme polyédrique dérivée d'une forme cubique.
Les figures 7a à 7d montrent une réalisation particulière d'un dispositif d'essai objet de l'invention qui se caractérise en ce qu'elle comporte trois septa dont les plans de couplage électromagnétique sont deux à deux distincts et non parallèles et dont la structure est de forme cubique.
Les figures 8a à 8d montrent une réalisation particulière d'un dispositif d'essai objet de l'invention dérivée du dispositif d'essai représentée aux figures 7a à 7d, qui se distingue de celle-ci par une autre disposition des septa.
Les figures 9a à 9d montrent une réalisation particulière d'un dispositif d'essai objet de l'invention extérieurement semblable au dispositif d'essai représenté aux figures 6a à 6d, qui se caractérise en ce qu'elle comporte deux groupes de trois septa. Pour chaque groupe de septa, les plans de couplage électromagnétique sont deux à deux orthogonaux.
Les figures 10a et 10b montrent deux exemples d'utilisation d'un dispositif d'essai objet de l'invention à trois septa dont les plans de couplage électromagnétique dans le volume d'essai sont deux à deux orthogonaux, pour des applications de mesure de rayonnement électromagnétique.
La figure 11 montre un exemple d'utilisation d'un dispositif d'essai objet de l'invention à trois septa dont les plans de couplage électromagnétique dans le volume d'essai sont deux à deux orthogonaux, pour des applications de mesure d'immunité électromagnétique.

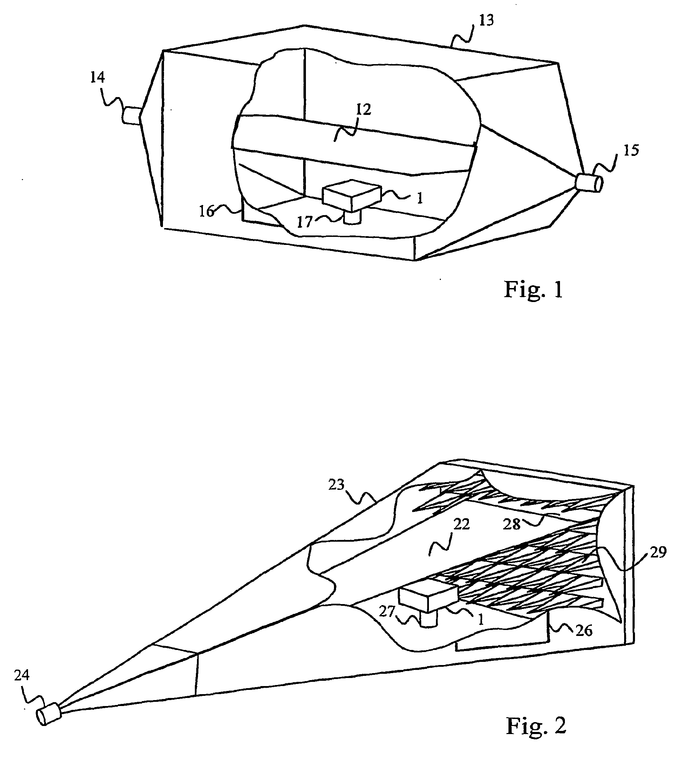

Sur la figure 1, qui représente une cellule TEM traditionnelle dont la partie centrale est de forme parallélépipédique, on reconnaît la structure conductrice 13 comportant une ouverture obturable 16 ; à l'intérieur de cette structure 13, on trouve le septum 12 raccordé aux connecteurs 14 et 15 situés aux extrémités de ladite structure ainsi que l'objet sous test 1 dont on veut mesurer les caractéristiques électromagnétiques, cet objet étant soutenu par un support diélectrique isolant 17.

Sur la figure 2, qui représente une cellule GTEM de forme pyramidale décrit dans le brevet US 4,837,581, on reconnaît la structure conductrice 23 comportant une ouverture obturable 26 ; à l'intérieur de cette structure, on trouve le septum 22 raccordé d'une part au connecteur 24 situé à une extrémité de ladite structure et d'autre part à un réseau de charges 28 à l'autre extrémité de ladite structure, ainsi que l'objet sous test 1 dont on veut mesurer les caractéristiques électromagnétiques, cet objet étant soutenu par un support diélectrique isolant 27. Un ensemble d'éléments absorbants 29 recouvrent la paroi interne à l'extrémité de la cellule où se trouve ledit réseau de charges.

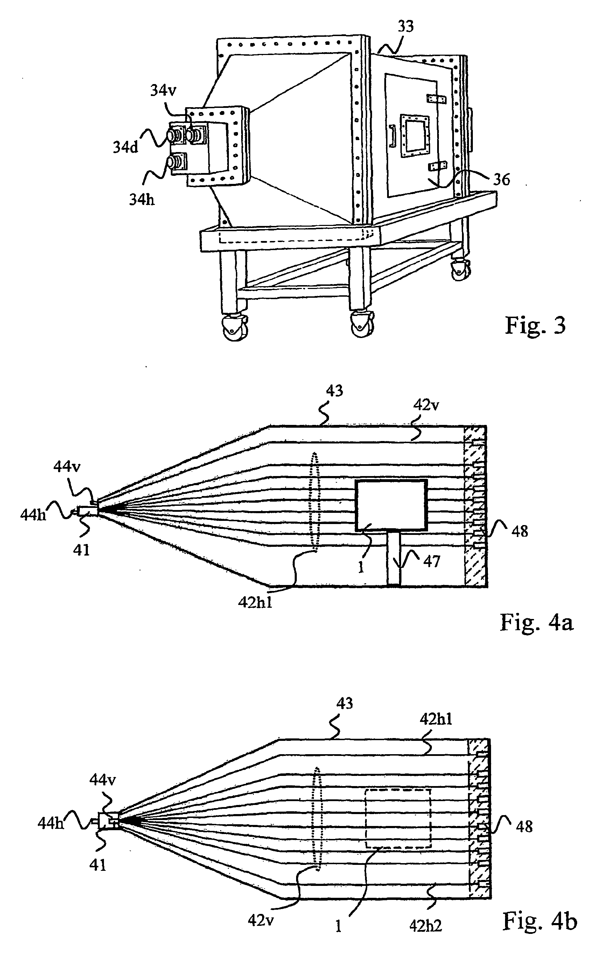

Sur la figure 3, qui représente une cellule TEM à trois septa et six connecteurs décrite dans le brevet US 5,793,215, on reconnaît la structure conductrice 33 comportant une ouverture obturable 36 ainsi que trois des six connecteurs 34v, 34h et 34d situés à une extrémité de ladite structure.

Sur les figures 4a et 4b, qui représentent deux coupes d'une cellule TEM à trois septa et deux connecteurs décrite dans le brevet US 5,861,753, on reconnaît la structure conductrice 43 à l'intérieur de laquelle on trouve l'objet à tester 1 soutenu par un support diélectrique isolant 47, les septa 42v, 42h1 et 42h2 raccordés à une extrémité de la structure par un réseau de charges 48 ; le septum 42v est raccordé à l'autre extrémité au connecteur 44v tandis que les septa 42h1 et 42h2 sont raccordés au connecteur 44h par le biais du coupleur 41.

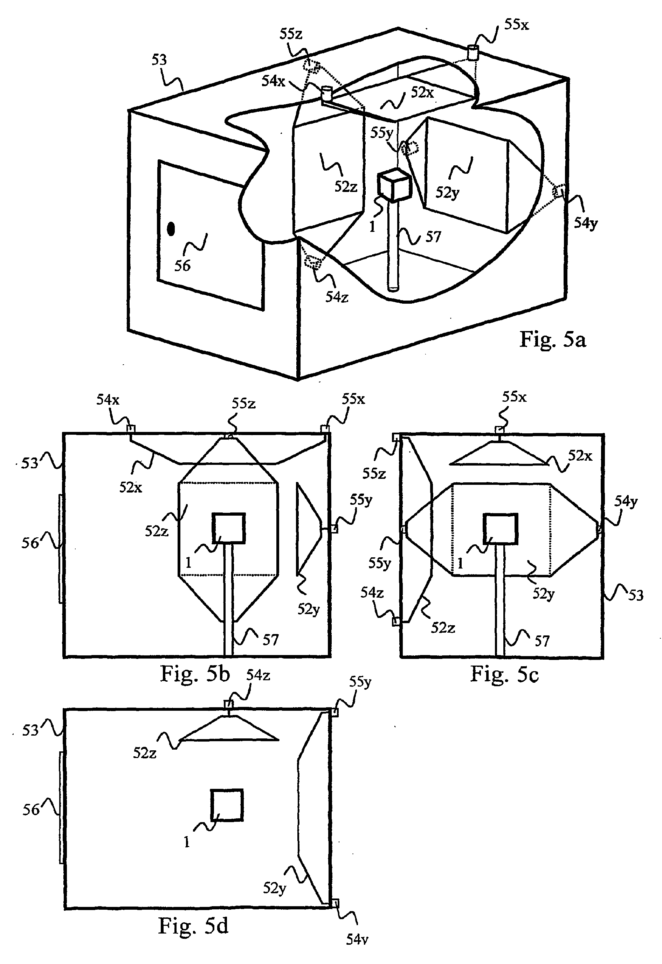

Sur les figures 5a à 5d qui représentent schématiquement un dispositif d'essai selon l'invention, de forme parallélépipédique, on reconnaît la structure conductrice 53 comportant une ouverture obturable 56 ; à l'intérieur de cette structure on trouve les septa 52x, 52y et 52z raccordés respectivement aux couples de connecteurs 54x et 55x, 54y et 55y, 54z et 55z, situés sur trois parois adjacentes de ladite structure, ainsi que l'objet sous test 1 dont on veut mesurer les caractéristiques électromagnétiques, cet objet étant soutenu par un support diélectrique isolant 57.

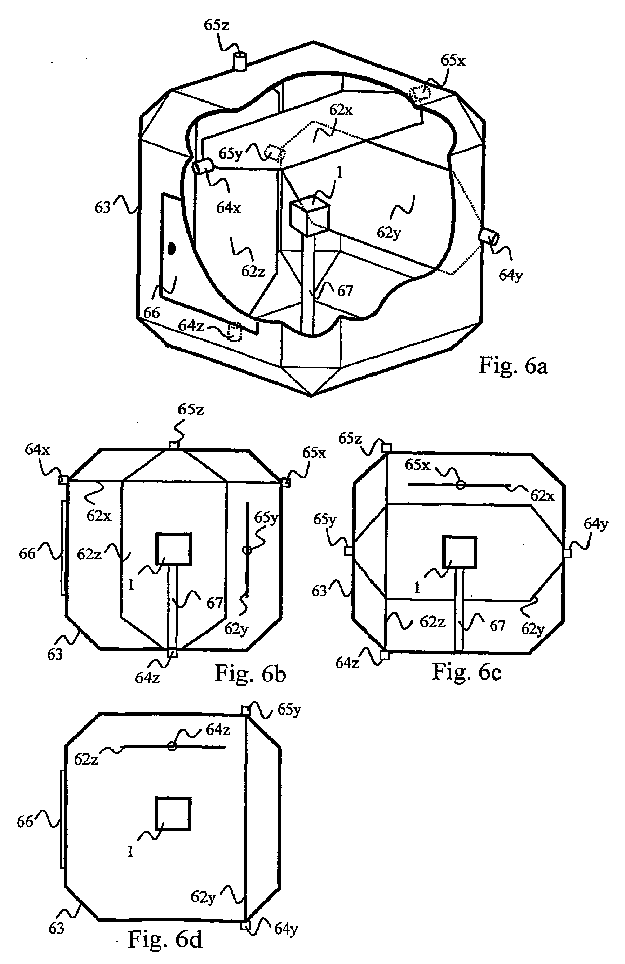

Sur les figures 6a à 6d qui représentent schématiquement une réalisation particulière d'un dispositif d'essai objet de l'invention dérivée du dispositif d'essai représenté aux figures 5a à 5d, on reconnaît la structure conductrice 63 comportant une ouverture obturable 66 ; à l'intérieur de cette structure on trouve les septa 62x, 62y et 62z raccordés respectivement aux couples de connecteurs 64x et 65x, 64y et 65y, 64z et 65z, situés sur trois parois adjacentes de ladite structure, ainsi que l'objet sous test 1 dont on veut mesurer les caractéristiques électromagnétiques, cet objet étant soutenu par un support diélectrique isolant 67.

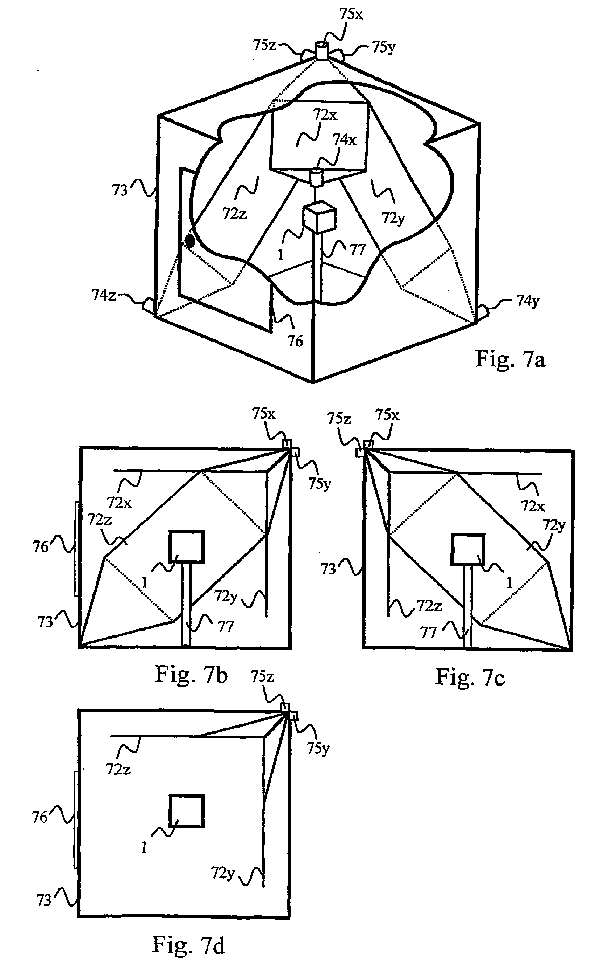

Sur les figures 7a à 7d qui représentent schématiquement une réalisation particulière d'un dispositif d'essai objet de l'invention, on reconnaît la structure conductrice 73 comportant une ouverture obturable 76 ; à l'intérieur de cette structure on trouve les septa 72x, 72y et 72z raccordés respectivement aux couples de connecteurs 74x et 75x, 74y et 75y, 74z et 75z, situés sur trois parois adjacentes de ladite structure, ainsi que l'objet sous test 1 dont on veut mesurer les caractéristiques électromagnétiques, cet objet étant soutenu par un support diélectrique isolant 77.

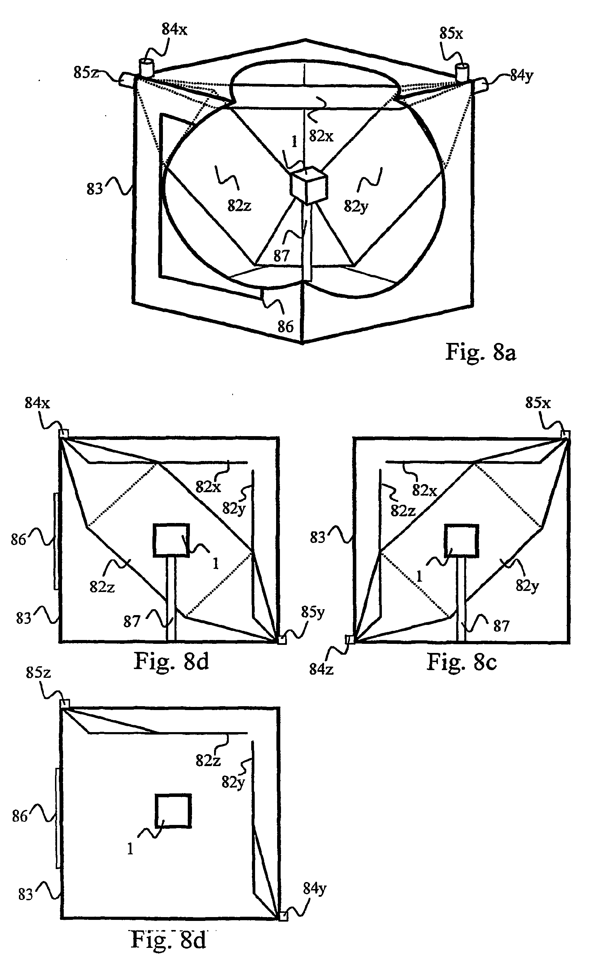

Sur les figures 8a à 8d qui représentent schématiquement une réalisation particulière d'un dispositif d'essai objet de l'invention, on reconnaît la structure conductrice 83 comportant une ouverture obturable 86 ; à l'intérieur de cette structure on trouve les septa 82x, 82y et 82z raccordés respectivement aux couples de connecteurs 84x et 85x, 84y et 85y, 84z et 85z, situés sur trois parois adjacentes de ladite structure, ainsi que l'objet sous test 1 dont on veut mesurer les caractéristiques électromagnétiques, cet objet étant soutenu par un support diélectrique isolant 87.

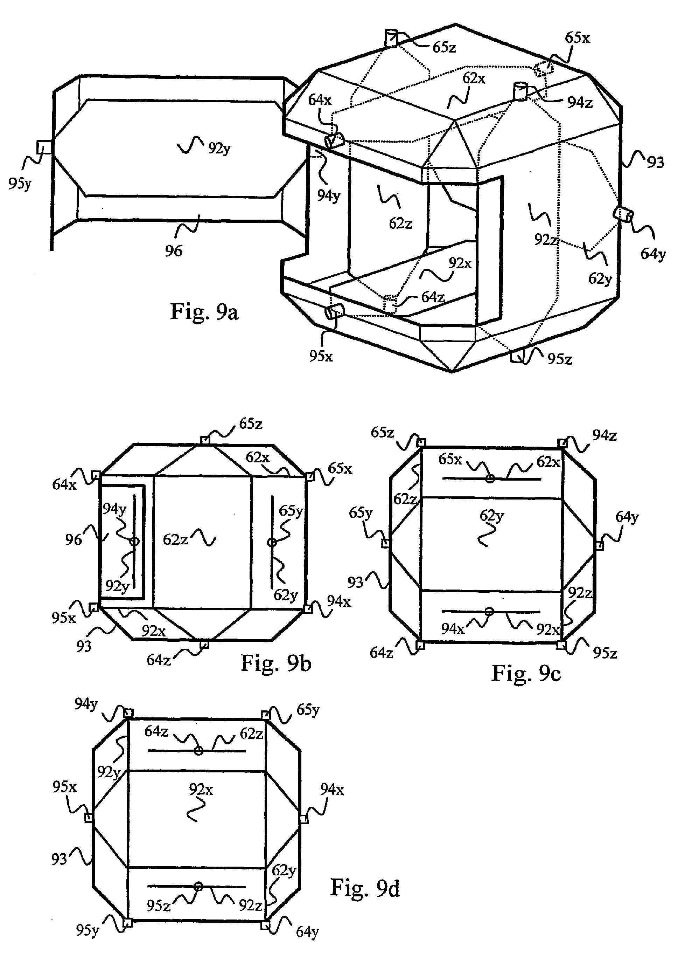

Sur les figures 9a à 9d qui représentent schématiquement une réalisation particulière d'un dispositif d'essai objet de l'invention, on reconnaît la structure conductrice 93 comportant une ouverture obturable 96 ; à l'intérieur de cette structure on trouve les septa 62x, 62y, 62z, 92x, 92y et 92z raccordés respectivement aux couples de connecteurs 64x et 65x, 64y et 65y, 64z et 65z, 94x et 95x, 94y et 95y, 94z et 95z, situés sur les six parois de ladite structure.

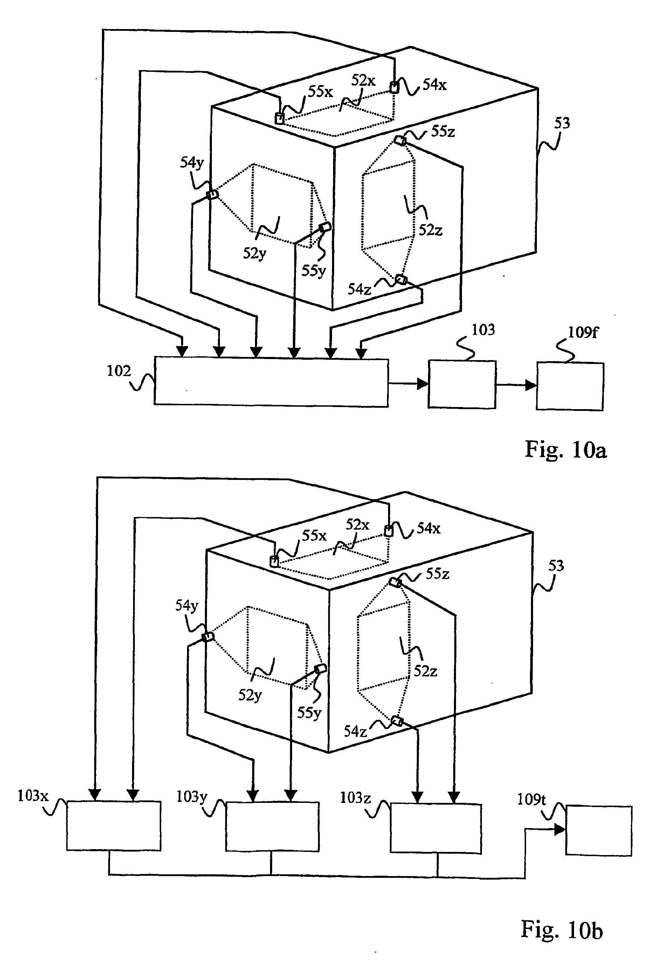

Sur la figure 10a on reconnaît le dispositif d'essai décrit aux figures 5a à 5d, en particulier sa structure 53, ses couples de connecteurs 54x et 55x, 54y et 55y, 54z et 55z qui relient respectivement les extrémités des septa 52x, 52y et 52z à un enregistreur 103 dans le domaine fréquentiel grâce à un sélecteur de voie 102, ainsi que le dispositif d'analyse fréquentielle du rayonnement électromagnétique 109f Ce dispositif d'essai applique par exemple le procédé de mesure de rayonnement électromagnétique, décrit dans le rapport du National Bureau of Standards NBS N° TN-1059 (PB83-165274) d'octobre 1982 : « A Method to Quantify the Radiation Characteristics of an Unknown Interference Source » (M.T. Ma et G.H. Koepke) pour une cellule TEM conventionnelle à deux connecteurs. Avec le dispositif d'essai représenté à la figure 10a, ce procédé est mis en oeuvre d'une manière similaire, en mesurant successivement les puissances recueillies aux connecteurs 54x et 55x, 54y et 55y, 54z et 55z, pour une même position de l'objet sous test dans le volume d'essai.

Sur la figure 10b on reconnaît le dispositif d'essai décrit aux figures 5a à 5d, en particulier sa structure 53, ses couples de connecteurs 54x et 55x, 54y et 55y, 54z et 55z qui relient respectivement les extrémités des septa 52x, 52y et 52z aux enregistreurs respectifs 103x, 103y et 103z dans le domaine temporel, ainsi que le dispositif d'analyse temporelle du rayonnement électromagnétique 109t. Ce dispositif d'essai applique par exemple le procédé de mesure de rayonnement électromagnétique, décrit dans la demande de brevet FR 99 11364 pour une cellule TEM conventionnelle à deux connecteurs ou pour une cellule GTEM à un connecteur. Avec le dispositif représenté à la figure 10b, ce procédé est mis en oeuvre de manière similaire, en mesurant simultanément les tensions recueillies aux connecteurs 54x et 55x, 54y et 55y, 54z et 55z, pour une même position de l'objet sous test dans le volume d'essai.

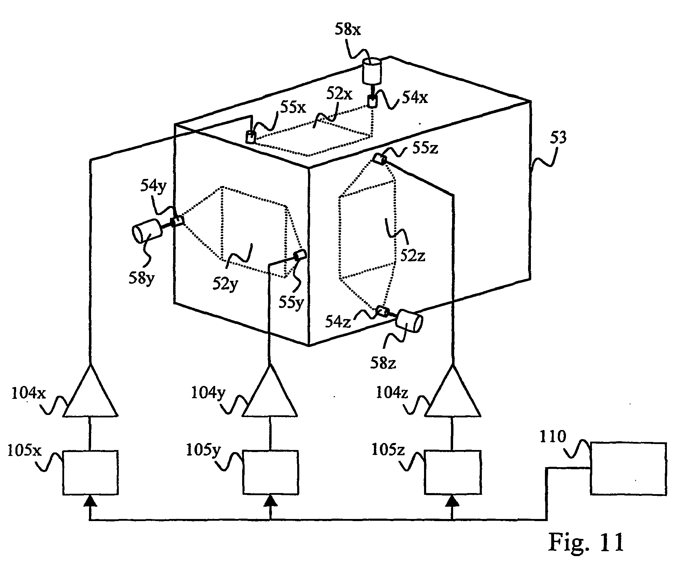

Sur la figure 11 on reconnaît le dispositif d'essai décrit aux figures 5a à 5d, en particulier sa structure 53 ainsi qu'un dispositif de contrôle 110 pilotant les synthétiseurs de fréquences 105x, 105y et 105z ; les sorties desdits synthétiseurs sont amplifiées respectivement par les amplificateurs 104x, 104y et 104z dont les sorties sont connectées respectivement aux septa 52x, 52y et 52z par les connecteurs 55x, 55y et 55z ; les connecteurs de traversée 54x, 54y et 54z relient respectivement l'autre extrémité desdits septa aux charges d'adaptation 58x, 58y et 58z. Ce dispositif d'essai applique par exemple le procédé de mesure d'immunité électromagnétique décrit dans la publication IEEE Transactions on Electromagnetic Compatibility, Vol. 16, N°4, de novembre 1974 : « Génération of Standard EM Fields using TEM Transmission Cells » (M. Crawford), en transmettant successivement ou simultanément des puissances électriques sur un des deux connecteurs aux extrémités de chaque septum 52x, 52y et 52z afin de créer un champ électromagnétique dans le volume d'essai où est placé l'objet sous test.

## Revendications

1. Dispositif d'essai permettant de mesurer le rayonnement, l'immunité électromagnétique et les caractéristiques électromagnétiques d'un objet à tester (1), comportant une structure conductrice (53) enveloppant un volume d'essai dans lequel on peut placer ledit objet, ladite structure étant de forme polyédrique possédant au moins six faces, ladite structure étant munie d'une ouverture obturable (56), ledit dispositif d'essai comportant également un ensemble de conducteurs internes appelés septa (52), en nombre au moins égal à deux, chaque septum étant composé d'au moins un conducteur élémentaire, chaque septum étant relié à deux connecteurs (54 et 55) traversant la structure conductrice (53), chaque connecteur étant relié à au moins un septum, chaque septum définissant dans ledit volume d'essai, par sa disposition dans la structure, un couplage électromagnétique avec ledit objet, ledit couplage électromagnétique étant précisé par un vecteur de couplage électrique et un vecteur de couplage magnétique définissant un plan de couplage électromagnétique passant par le point à tester et perpendiculaire à la direction de circulation du courant dans ledit septum, au moins un septum étant disposé de telle manière que son plan de couplage électromagnétique soit distinct et non parallèle au plan de couplage électromagnétique d'au moins un autre septum, **caractérisé en ce que** ledit dispositif d'essai comporte trois septa disposés de telle sorte que leurs plans de couplage électromagnétique soient deux à deux distincts et non parallèles.

2. Dispositif d'essai selon la revendication 1, **caractérisé en ce que** les plans de couplage électromagnétique des septa sont deux à deux orthogonaux.

3. Dispositif d'essai selon la revendication 1, **caractérisé en ce qu'**il comporte deux groupes de trois septa, les septa de chaque groupe étant disposés de telle sorte que leurs plans de couplage électromagnétique soient deux à deux distincts et non parallèles.

4. Dispositif d'essai selon la revendication 3, **caractérisé en ce que** les septa de chaque groupe sont disposés de telle sorte que leurs plans de couplage électromagnétique soient deux à deux orthogonaux.

5. Dispositif d'essai selon la revendication 1, **caractérisé en ce que** la structure conductrice (53) est de forme parallélépipédique.

6. Dispositif d'essai selon la revendication 5, **caractérisé en ce que** les rapports des dimensions de la forme parallélépipédique de la structure conductrice (53), prises deux à deux sont des nombres irrationnels.

7. Dispositif d'essai selon la revendication 5, **caractérisé en ce que** la structure conductrice (53) est de forme cubique.

8. Dispositif d'essai selon la revendication 1, **caractérisé en ce que** tout ou partie de la face intérieure de la structure conductrice (53) est recouverte d'un matériau absorbant l'énergie électromagnétique.

9. Dispositif d'essai selon la revendication 1, **caractérisé en ce que** le volume intérieur de la structure conductrice (53) comporte des éléments destinés au brassage du rayonnement électromagnétique.

## Claims

1. A test device allowing measurement of the radiation, the electromagnetic immunity and the electromagnetic characteristics of an object (1) to be tested, including a conducting structure (53) encasing a test volume in which said object may be placed, said structure being of polyhedral shape having at least six faces, said structure being provided with an obturatable aperture (56), said test device also including a set of internal conductors called septa (52), at least two in number, each septum consisting of at least one elementary conductor, each septum being connected to two connectors (54 and 55) passing through the conducting structure (53), each connector being connected to at least one septum, each septum defining in said test volume, by its arrangement in the structure, an electromagnetic coupling with said object, said electromagnetic coupling being specified by an electric coupling vector and a magnetic coupling vector defining an electromagnetic coupling plane passing through the point to be tested and perpendicular to the direction of flow of the current in said septum, at least one septum being arranged so that its electromagnetic coupling plane is distinct and not parallel to the electromagnetic coupling plane of at least one other septum, **characterized in that** said test device includes three septa arranged so that their electromagnetic coupling planes are distinct two by two and not parallel.

2. The test device according to claim 1, **characterized in that** the electromagnetic coupling planes of the septa are orthogonal two by two.

3. The test device according to claim 1, **characterized in that** it includes two groups of three septa, the septa of each group being arranged so that their electromagnetic coupling planes are distinct two by two and not parallel.

4. The test device according to claim 3, **characterized in that** the septa of each group are arranged so that their electromagnetic coupling planes are orthogonal two by two.

5. The test device according to claim 1, **characterized in that** the conducting structure (53) is of a parallelepipedal shape.

6. The test device according to claim 1, **characterized in that** the ratios of the dimensions of the parallelepipedal shape of the conducting structure (53), taken two by two, are irrational numbers.

7. The test device according to claim 5, **characterized in that** the conducting structure (53) is of a cubic shape.

8. The test device according to claim 1, **characterized in that** all or part of the inner face of the conducting structure (53) is covered with a material absorbing electromagnetic energy.

9. The test device according to claim 1, **characterized in that** the inner volume of the conducting structure (53) includes elements for mixing the electromagnetic radiation.

## Patentansprüche

1. Testvorrichtung zum Messen der Strahlung, der elektromagnetischen Immunität und der elektromagnetischen Merkmale eines Testgegenstands (1), die eine leitende Struktur (53) umfasst, die ein Testvolumen ummantelt, in das der Gegenstand platzierbar ist, wobei die Struktur eine polyedrische Form mit mindestens sechs Seiten aufweist, wobei die Struktur mit einer verschließbaren Öffnung (56) ausgestattet ist, wobei die Testvorrichtung ebenfalls eine Gruppe interner, Septa (52) genannte Leiter in einer mindestens paarweisen Anzahl aufweist, wobei jedes Septum aus mindestens einem elementaren Leiter besteht, wobei jedes Septum mit zwei Leitern (54 und 55) verbunden ist, die die leitende Struktur (53) durchqueren, wobei jeder Leiter mit mindestens einem Septum verbunden ist, wobei jedes Septum im Testvolumen durch seine Anordnung in der Struktur eine elektromagnetische Kopplung mit dem Gegenstand definiert, wobei die elektromagnetische Kopplung durch einen Vektor elektrischer Kopplung und einen Vektor magnetischer Kopplung präzisiert ist, was eine elektrische Kopplungsebene definiert, die durch den zu testenden Punkt verläuft und senkrecht zur Zirkulationsrichtung des Stroms in dem Septum, wobei mindestens ein Septum derart angeordnet ist, dass seine elektromagnetische Kopplungsebene unterschiedlich und nicht parallel zur elektromagnetischen Kopplungsebene mindestens eines anderen Septums ist, **dadurch gekennzeichnet, dass** die Testvorrichtung drei Septa aufweist, die derart angeordnet sind, dass ihre elektromagnetischen Kopplungsebenen paarweise unterschiedlich und nicht parallel sind.

2. Testvorrichtung nach Anspruch 1, **dadurch gekennzeichnet, dass** die elektromagnetischen Kopplungsebenen der Septa paarweise orthogonal sind.

3. Testvorrichtung nach Anspruch 1, **dadurch gekennzeichnet, dass** sie zwei Gruppen mit drei Septa aufweist, wobei die Septa jeder Gruppe derart angeordnet sind, dass ihre elektromagnetischen Kopplungsebenen paarweise unterschiedlich und nicht parallel sind.

4. Testvorrichtung nach Anspruch 3, **dadurch gekennzeichnet, dass** die Septa jeder Gruppe derart angeordnet sind, dass ihre elektromagnetischen Kopplungsebenen paarweise orthogonal sind.

5. Testvorrichtung nach Anspruch 1, **dadurch gekennzeichnet, dass** die leitende Struktur (53) parallelepipedisch ist.

6. Testvorrichtung nach Anspruch 5, **dadurch gekennzeichnet, dass** die Größenverhältnisse der parallelepipedischen Form der leitenden Struktur (53), paarweise betrachtet, irrationale Größen sind.

7. Testvorrichtung nach Anspruch 5, **dadurch gekennzeichnet, dass** die leitende Struktur (53) kubischer Form ist.

8. Testvorrichtung nach Anspruch 1, **dadurch gekennzeichnet, dass** die Innenseite der leitenden Struktur (53) ganz oder teilweise mit einem elektromagnetische Energie absorbierenden Werkstoff beschichtet ist.

9. Testvorrichtung nach Anspruch 1, **dadurch gekennzeichnet, dass** das Innenvolumen der leitenden Struktur (53) Elemente aufweist, die zur Bewegung der elektromagnetischen Strahlung bestimmt sind.
